## Europäisches Patentamt
## European Patent Office
## Office européen des brevets

(11) Veröffentlichungsnummer: **0 062 759**
**B1**

(12) **EUROPÄISCHE PATENTSCHRIFT**

(45) Veröffentlichungstag der Patentschrift:
**16.01.85**

(21) Anmeldenummer: **82101770.4**

(22) Anmeldetag: **06.03.82**

(51) Int. Cl.⁴: **G 01 R 5/16**

(54) **Kreuzspuldrehmagnet-Messgerät.**

(30) Priorität: **03.04.81 DE 3113500**

(43) Veröffentlichungstag der Anmeldung:
**20.10.82 Patentblatt 82/42**

(45) Bekanntmachung des Hinweises auf die Patenterteilung:
**16.01.85 Patentblatt 85/3**

(84) Benannte Vertragsstaaten:
**DE FR GB**

(56) Entgegenhaltungen:
**EP - A - 0 021 181**
**DE - C - 1 118 878**
**DE - U - 1 966 278**

(73) Patentinhaber: **VDO Adolf Schindling AG,**
**Gräfstrasse 103, D-6000 Frankfurt/Main (DE)**

(72) Erfinder: **Foerste, Rudolf, Dahlienweg 22,**
**D-6382 Friedrichsdorf (DE)**

(74) Vertreter: **Könekamp, Herbert, Dipl.-Ing., Sodener**
**Strasse 9, D-6231 Schwalbach (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Kreuzspuldrehmagnet-Messgerät mit an ein Zeigerwerk koppelbarem, in mindestens einer Richtung magnetisiertem Rotor, der in einem Spulenträger für die das Messsignal aufnehmende Erregerwicklung gelagert ist, und mit einem Rückstellmagnet, dessen Magnetisierungsrichtung zur Magnetisierung des Rotors beliebig festgelegt werden kann. Ein solches Kreuzspuldrehmagnet-Messgerät ist in der DE-C Nr. 1118878 sowie der EP-A Nr. 0021181 beschrieben.

Bei Kreuzspuldrehmagnet-Messgeräten ist es notwendig, einen Rückstellmagnet vorzusehen, der den durch die Verstellkraft des Wicklungssystems in eine bestimmte Einstellage gebrachten Rotor nach Abschaltung des Messstromes in seine Ausgangslage zurückführt. Bei dem bekannten Kreuzspuldrehmagnet-Messgerät ist der Rückstellmagnet aus einem Drahtring gebildet, der unterhalb des Rotors koaxial zu ihm im Spulenträger eingesetzt und in einem Ringdurchmesser magnetisiert ist. Der wesentliche Vorteil dieses Kreuzspuldrehmagnet-Messgerätes liegt darin, dass sein Rückstellmagnet in jeder beliebigen Durchmesserrichtung magnetisiert werden kann, so dass für verschiedene Kreuzspuldrehmagnet-Messgeräte eine Anpassung an verschiedene Ausgangslagen des Rotors möglich ist.

Da Kreuzspuldrehmagnet-Messgeräte für zahlreiche Anwendungsfälle einsetzbar sind, z.B. als elektrisch arbeitende Tachometer oder als Kraftstoffmesser in Kraftfahrzeugen, stellen sie Massenprodukte dar, die möglichst billig herstellbar sein sollen, wobei eine Verbilligung in der Grössenordnung von wenigen Pfennigen schon einen grossen Fortschritt darstellen würde. Hiervon abgesehen sollen Kreuzspuldrehmagnet-Messgeräte möglichst kompakt sein, damit sie möglichst wenig Platz einnehmen.

Aus der DE-U Nr. 1966278 ist ein Drehspulmessgerät mit einem Rückstellmagnet bekannt, bei dem in einen aus Kunststoff bestehenden Gehäusedeckel ein Magnetstreifen eingebettet bzw. eingebunden ist.

Der Erfindung liegt die Aufgabe zugrunde, ein Kreuzspuldrehmagnet-Messgerät der eingangs genannten Art zu entwickeln, welches möglichst billig herstellbar ist und weiterhin möglichstkompakt gebaut ist.

Diese Aufgabe wird auf überraschend einfache Weise durch die im Anspruch 1 angegebenen Massnahmen gelöst.

Der Vorteil der Erfindung ergibt sich zunächst in bezug auf die Fertigung aus der Tatsache, dass das erfindungsgemässe Kreuzspuldrehmagnet-Messgerät im Vergleich zu den bekannten Kreuzspuldrehmagnet-Messgeräten Bauteile weniger enthält, weil der Rückstellmagnet als separates Bauteil überflüssig wird. Dadurch ist das erfindungsgemässe Kreuzspuldrehmagnet-Messgerät billiger und zugleich kompakter als das vorbekannte. Da der Spulenträger genau in der erforderlichen Richtung magnetisiert werden kann, genügen relativ geringe Magnetkräfte, um die gewünschte Rückstellung des Rotors des Kreuzspuldrehmagnet-Messgerätes zu erzielen. Dies ist wichtig, weil der Rückstellmagnet der vom Messstrom erzeugten Stellkraft, die auf den Rotor und damit den Zeiger wirkt, entgegenwirkt.

Wenn man auf eine Verkleinerung des Bauvolumens keinen Wert legt, dann erhält man durch die Erfindung die Möglichkeit, bei Beibehaltung des Bauvolumens den durch den Wegfall eines separaten Rückstellmagneten gewonnenen Raum zur Vergrösserung der Erregerwicklung oder des Rotors zu verwenden, was zu grösseren Verstellkräften im Kreuzspuldrehmagnet-Messgerät führt.

Durch die im Anspruch 2 angegebene Massnahme erreicht man, dass auch mit relativ wenig im Spulenträger eingebundenen Magnetteilchen eine ausreichend hohe Magnetkraft zu erzielen ist.

Durch die im Anspruch 3 angegebene vorteilhafte Ausgestaltung der Erfindung wird es möglich, die gewünschte Rückstellkraft auf einfache Weise den speziellen Geräteerfordernissen anzupassen.

Die Erfindung lässt zahlreiche Ausführungsmöglichkeiten zu. Eine davon ist in der Zeichnung schematisch dargestellt und wird nachfolgend beschrieben.

Es zeigen:

Fig. 1 einen erfindungsgemäss gestalteten Spulenträger von unten gesehen;

Fig. 2 einen Querschnitt durch den die Erfindung kennzeichnenden Bereich des Kreuzspuldrehmagnet-Messgerätes.

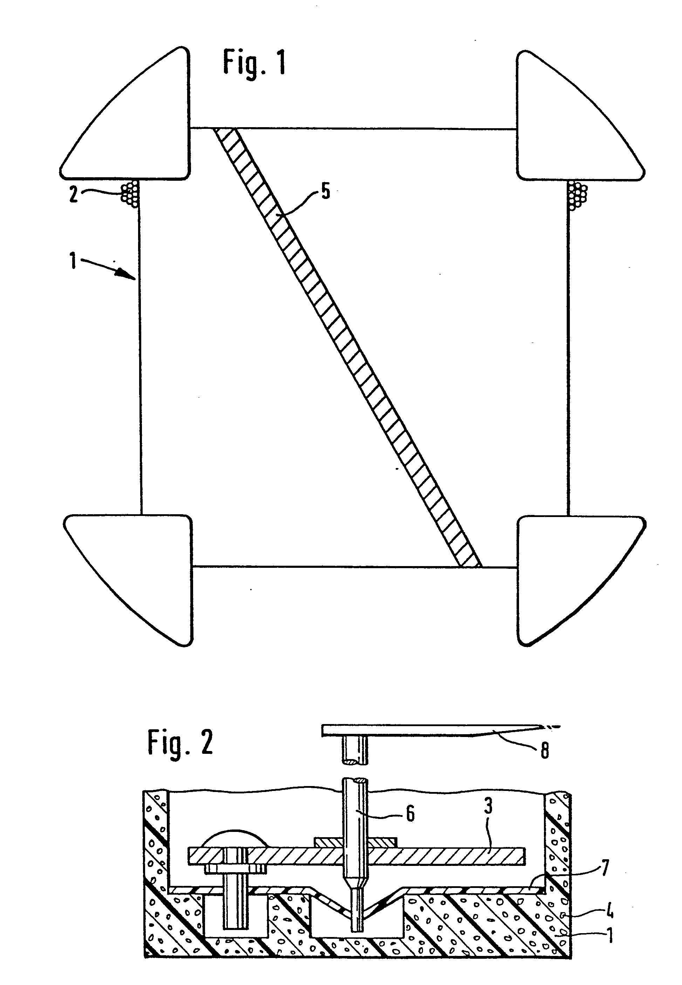

Bei dem in Fig. 1 dargestellten Spulenträger 1 sind im Schnitt nur wenige Windungen 2 der Erregerwicklung gezeigt, durch welche bei Stromfluss eine Kraftwirkung auf einen in Fig. 2 dargestellten Rotor 3 ausgeübt wird. Der Spulenträger 1 ist wie üblich aus Kunststoff gefertigt. In diesen Kunststoff sind jedoch, was in Fig. 2 angedeutet wurde, Magnetteilchen 4 eingebunden, welche sich in ihren mechanischen und thermischen Eigenschaften vom übrigen Kunststoff nicht unterscheiden. Durch diese Magnetteilchen ist es möglich, durch Magnetisieren den Spulenträger unmittelbar nach seiner Herstellung mit einer in Fig. 1 gezeigten Magnetspur 5 auszustatten, welche die Bedeutung eines Rückstellmagneten hat.

Zum besseren Verständnis des Kreuzspuldrehmagnet-Messgerätes als Ganzes ist in Fig. 2 gezeigt, wie der Rotor 3 mittels einer Welle 6 auf einer Lagerplatte 7 gelagert ist. Die Welle 6 trägt einen Zeiger 8.

Die Magnetteilchen 4 brauchen nicht überall im Spulenträger 1 vorgesehen zu sein, vielmehr sollen sie vorzugsweise nur in dem Bereich eingebunden sein, in welchem die Magnetspur 5 verläuft. Dies ist durch Impfen des Spulenträgers mit den Magnetteilchen leicht durchzuführen. Denkbar ist es auch, den mit Magnetteilchen dotierten Bereich definiert dreidimensional auszubilden, um ihn den Erfordernissen des jeweiligen Kreuzspuldrehmagnet-Messgerätes anzupassen. Auf diese Weise können beispielsweise unterschiedliche Formen des Verlaufs der Magnetspur erzeugt werden, um beispielsweise einen Nullpunkt in Skalenmitte zu erhalten oder aber die Kennlinie des Messgerätes linear oder nicht linear zu beeinflussen.

## Patentansprüche

1. Kreuzspuldrehmagnet-Messgerät mit an ein Zeigerwerk koppelbarem, in mindestens einer Richtung magnetisiertem Rotor (3), der in einem Spulenträger (1) für die das Messsignal aufnehmende Erregerwicklung gelagert ist, und mit einem Rückstellmagnet, dessen Magnetisierungsrichtung zur Magnetisierung des Rotors beliebig festgelegt werden kann, dadurch gekennzeichnet, dass der Rückstellmagnet durch in den Kunststoff des Spulenträgers (1) eingebundene Magnetteilchen (4) gebildet ist.

2. Kreuzspuldrehmagnet-Messgerät nach Anspruch 1, dadurch gekennzeichnet, dass der Spulenträger (1) nur in einem Bereich Magnetteilchen (4) enthält, in welchem der Rückstellmagnet vorgesehen sein muss.

3. Kreuzspuldrehmagnet-Messgerät nach einem der Ansprüche 1 oder 2, dadurch gekennzeichnet, dass die Magnetteilchen (4) eine radial verlaufende Magnetspur (5) bilden, deren Breite sich entsprechend den erforderlichen Rückstellkräften bemisst.

## Claims

1. Crossed-coil moving-magnet measuring apparatus with a rotor (3) which is couplable to a pointer mechanism, is magnetised in at least one direction, and is mounted in a coil support (1) for the excitation winding receiving the measurement signal, and with a resetting magnet, the magnetisation direction of which can be optionally fixed for magnetisation of the rotor, characterised in that the resetting magnet is formed by magnetic particles (4) bonded into the synthetic plastic material of the coil support (1).

2. Crossed-coil moving-magnet measuring apparatus according to Claim 1, characterised in that the coil support (1) contains magnetic particles (4) only in one region where the resetting magnet has to be arranged.

3. Crossed-coil moving-magnet measuring apparatus according to one of Claims 1 or 2, characterised in that the magnetic particles (4) form a radially disposed magnetic track (5), the width of which is dimensioned in accordance with the resetting forces which are required.

## Revendications

1. Appareil de mesure à aimant tournant à enroulement croisé comportant un rotor (3) pouvant être relié à un équipement indicateur, aimanté au moins dans un sens et monté dans un porte-bobine (1) portant l'enroulement inducteur qui reçoit le signal de mesure, ainsi qu'un aimant de rappel dont le sens d'aimantation pour aimanter ce rotor peut être déterminé à volonté, appareil caractérisé en ce que l'aimant de rappel est formé de particules magnétiques (4) enrobées dans la matière plastique de ce porte-bobine (1).

2. Appareil de mesure selon la revendication 1, caractérisé en ce que le porte-bobine (1) ne contient de particules magnétiques (4) qu'à un emplacement où l'aimant de rappel doit être prévu.

3. Appareil de mesure selon l'une des revendications 1 ou 2, caractérisé en ce que les particules magnétiques (4) forment une piste magnétique (5) radiale, dont la largeur est déterminée en fonction de la force de rappel nécessaire.

# Fig. 1

# Fig. 2